# EUROPÄISCHE PATENTSCHRIFT

(11) **EP 4 384 839 B1**
(45) Veröffentlichungstag und Bekanntmachung des Hinweises auf die Patenterteilung: **03.09.2025**
(21) Anmeldenummer: 22757508.1
(22) Anmeldetag: 22.07.2022
(51) Int. Cl.: G01R 33/30, G01N 24/00, G01N 24/10, G01R 33/32

(54) **VORRICHTUNG FÜR DIE ANALYSE EINER ALS TROPFEN BEREITGESTELLTEN FLÜSSIGEN ODER PASTÖSEN PROBE ANHAND VON KERNSPINRESONANZEN DER PROBE**
DEVICE FOR ANALYZING A LIQUID OR PASTY SAMPLE, WHICH IS PROVIDED IN THE FORM OF DROPS, USING NUCLEAR MAGNETIC RESONANCES OF THE SAMPLE
DISPOSITIF D'ANALYSE D'UN ÉCHANTILLON LIQUIDE OU PÂTEUX, SOUS FORME DE GOUTTES, AU MOYEN DES RÉSONANCES MAGNÉTIQUES NUCLÉAIRES DE L'ÉCHANTILLON

(30) Priorität: 11.08.2021 DE 102021120972
(43) Veröffentlichungstag der Anmeldung: 19.06.2024
(73) Patentinhaber: Analytik Jena GmbH+Co. KG, 07745 Jena (DE)
(72) Erfinder: MOORE, Thomas, 07751 Jena-Drackendorf (DE); WEIGEL, Daniel, 07743 Jena (DE); EBRAHIMI, Mohammad Sadegh, 79539 Lörrach (DE)
(74) Vertreter: Endress + Hauser Group Services (Deutschland) AG+Co. KG
(86) Internationale Anmeldenummer: PCT/EP2022/070603
(87) Internationale Veröffentlichungsnummer: WO 2023/016775

(56) Entgegenhaltungen:
- WO-A1-2021/064687
- DE-A1- 102014 219 561
- DE-A1- 19 927 976
- US-A1- 2011 062 957

## Beschreibung

Die Erfindung betrifft eine Vorrichtung für die Analyse einer als Tropfen bereitgestellten flüssigen oder pastösen Probe anhand von Kernspinresonanzen der Probe.

Die Kernspinresonanzspektroskopie (NMR-Spektroskopie) erlaubt die Untersuchung der elektronischen Umgebung einzelner Atome sowie deren Wechselwirkungen mit den Nachbaratomen. So können mittels der NMR-Spektroskopie die Komponenten von Proben und die Strukturen von Molekülen bestimmt werden. Die NMR-Spektroskopie bildet auch die Basis der Magnetresonanztomographie, welche häufig im medizinischen oder biologischen Bereich zur Untersuchung von Geweben und Organen eingesetzt wird.

Viele Atomkerne weisen einen von Null verschiedenen Kernspin und damit als rotierende Ladungsträger ein magnetisches Moment auf, so wie beispielsweise ¹H- oder ¹³C-Atome. Die Kernspins führen in einem statischen Magnetfeld eine präzidierende Bewegung, die sogenannten Larmorpräzession, um die Achse des konstanten Magnetfelds durch. Dabei ändern die Atomkerne die Orientierung ihrer Kernspins zum Magnetfeld durch die Absorption oder Emission von magnetischen Wechselfeldern, wenn diese resonant mit der Larmorfrequenz sind. Dieser Effekt ist auch als Kernspinresonanz bekannt. Die möglichen magnetischen Drehimpulsquantenzustände der Kernspins sind dabei äquidistant und abhängig von der Larmorfrequenz. Die Frequenz und die Dauer der Larmorpräzession sind abhängig von dem jeweiligen Kernspin, sowie seiner räumlichen und chemischen Umgebung. Die Detektion der Larmorpräzessionen anhand der Larmorfrequenzen ermöglicht somit eine sehr genaue Bestimmung der chemischen Zusammensetzung der Probe und der räumlichen Struktur der in der Probe enthaltenen Moleküle.

Das magnetische Wechselfeld wird in der Regel durch eine Magnetspule erzeugt. In der konventionellen NMR-Spektroskopie werden häufig induktive Verfahren zur Detektion der Kernspinresonanzen verwendet. So ist die Probe häufig von einer Induktionsspule umgeben, in welcher eine elektrische Spannung durch die von den präzidierenden Kernspins emittierten magnetischen Wechselfelder erzeugt wird. Typischerweise werden starke statische Magnetfelder von bis zu 25 T zur Polarisierung der Kernspins eingesetzt, um eine Vorzugspolarisation von gleichartig ausgerichteten Kernspins und somit eine Magnetisierung zu erhalten, die mit herkömmlichen Magnetfeldsensoren messbar ist. Eine Miniaturisierung der NMR-Messgeräte ist damit in der Regel nicht möglich. Die zu untersuchende Probe wird in der Regel in langes Glasröhrchen eingebracht. Das benötigte Probenvolumen liegt bei wenigen Millilitern. Insbesondere im Life Science Bereich ist dies jedoch ein großer Nachteil, da die zur Verfügung stehenden Volumina der Proben häufig im Mikroliterbereich liegen. So können beispielsweise häufig nur wenige Mikroliter Probe aus Zellkulturen oder Gewebepunkten extrahiert werden.

Eine neuere Generation von Magnetfeldsensoren fällt in den Bereich der sogenannten Quantensensoren, bei welchen unterschiedlichste Quanteneffekte zur Bestimmung verschiedener physikalischer und/oder chemischer Messgrößen ausgenutzt werden. Im Bereich der industriellen Prozessautomatisierung sind solche Ansätze insbesondere mit Hinblick auf ein zunehmendes Bestreben zur Miniaturisierung bei gleichzeitiger Steigerung der Leistungsfähigkeit der jeweiligen Sensoren interessant.

Quantensensoren basieren darauf, dass bestimmte Quantenzustände einzelner Atome sehr genau kontrolliert und ausgelesen werden können. Auf diese Weise sind beispielsweise präzise und störungsarme Messungen von elektrischen und/oder magnetischen Feldern sowie Gravitationsfeldern mit Auflösungen im Nanometerbereich möglich. In diesem Zusammenhang sind verschiedene Spin-basierte Sensoranordnungen bekannt geworden, für welche atomare Übergänge in Kristallkörpern zur Detektion von Änderungen von Bewegungen, elektrischen und/oder magnetischen Feldern oder auch Gravitationsfeldern eingesetzt werden. Darüber hinaus sind auch unterschiedliche auf quantenoptischen Effekten basierende Systeme bekannt geworden, wie beispielsweise Quantengravimeter oder optisch gepumpte Magnetometer, wobei insbesondere letztere u.a. auf Gaszellen basieren.

Beispielsweise sind im Bereich Spin-basierter Quantensensoren verschiedene Vorrichtungen bekannt geworden, welche atomare Übergänge, beispielsweise in verschiedenen Kristallkörpern, ausnutzen, um bereits geringe Änderungen von Bewegungen, elektrischen und/oder magnetischen Feldern oder auch Gravitationsfeldern zu erkennen. Typischerweise wird als Kristallkörper Diamant mit zumindest einem Silizium- oder Stickstoff-Fehlstellen-Zentrum, Siliziumcarbid mit zumindest einer Silizium-Fehlstelle oder hexagonales Bornitrid mit zumindest einem Fehlstellen-Farbzentrum verwendet. Die Kristallkörper können grundsätzlich ein oder mehrere Fehlstellen aufweisen.

Ein weiterer Teilbereich im Feld von Quantensensoren betrifft Gaszellen, in welchen atomare Übergänge sowie Spinzustände u.a. zur Bestimmung magnetischer und/elektrischer Eigenschaften optisch abgefragt werden können. In der Regel liegen in der Gaszelle ein gasförmiges Alkalimetall sowie ein Puffergas vor. Magnetische Eigenschaften eines umgebenden Mediums können durch in der Gaszelle erzeugte Rydbergzustände bestimmt werden. Beispielsweise werden Gaszellen in quantenbasierten Standards eingesetzt, welche physikalische Größen mit hoher Präzision bereitstellen. So werden sie seit langem in Frequenzstandards bzw. Atomuhren eingesetzt, wie aus der EP 0 550 240 B1 bekannt.

Vorrichtungen für ODMR oder NMR sind u.a. bekannt geworden aus der WO 2021/064687 A1, der DE 199 27 976 A1 und der DE 10 2014 219 561 A1.

Es ist daher Aufgabe der vorliegenden Erfindung, eine Vorrichtung anzugeben, mittels welcher die Kernspinresonanzen kleiner Probenvolumina, z.B. unter 100 µl, auf einfache Weise detektiert werden können.

Die Aufgabe wird erfindungsgemäß gelöst durch eine Vorrichtung für die Analyse einer als Tropfen bereitgestellten flüssigen oder pastösen Probe anhand von Kernspinresonanzen der Probe, mit
- einer ersten Platte und einer zweiten Platte,
- einem Mechanismus, über welchen eine Messposition und eine Aufnahmeposition einstellbar ist, wobei in der Aufnahmeposition die Probe zwischen der ersten Platte und der zweiten Platte einbringbar ist, wobei in der Messposition die erste Platte und die zweite Platte im Wesentlichen parallel zueinander angeordnet sind und ein Abstandshalter einen definierten Abstand zwischen der ersten Platte und der zweiten Platte einstellt,
- einer Sensoreinheit mit einer Sensorkomponente, welche zumindest einen Teilbereich der ersten Platte und/oder der zweiten Platte bildet und zumindest teilweise in Kontakt mit der Probe steht, wobei die Sensoreinheit dazu ausgestaltet ist, eine von den Kernspinresonanzen der Probe beeinflusste Größe zu detektieren,
- einer Auswerteeinheit, welche ausgestaltet ist, anhand der detektierten Größe mindestens eine chemische und/oder physikalische Eigenschaft der Probe zu ermitteln.

In der erfindungsgemäßen Vorrichtung wird die Probe zwischen der ersten Platte und der zweiten Platte eingespannt. Die Probe wird dabei durch die Grenzflächenspannung zwischen der Probe und den zwei Platten und der Adhäsionskraft der Probe zu den beiden Platten statisch gehalten. Mithilfe des Abstandshalters wird ein definierter Abstand zwischen den zwei Platten und somit eine definierte Schichtdicke der Probe eingestellt, wobei der definierte Abstand in Abhängigkeit der Eigenschaften der Probe und der Oberflächenbeschaffenheit der beiden Platten eingestellt wird. Die Eigenschaften der Probe und die Oberflächenbeschaffenheit der beiden Platten beziehen sich insbesondere auf ihre Hydrophobie/Hydrophilie und Lipophilie/Lipophobie, sowie im Fall der Oberflächenbeschaffenheit auf die Rauheit der der Probe zugewandten Flächen der beiden Platten.

In der Aufnahmeposition der Vorrichtung wird die Probe beispielsweise auf die erste Platte oder die zweite Platte mittels einer Pipette aufgebracht. Durch das Einstellen der Messposition und der damit verbundenen parallelen Anordnung der beiden Platten wird die als Tropfen eingebrachte Probe abgeflacht und so die Kontaktfläche der Probe zu der ersten Platte und der zweiten Platte stark vergrößert. Der definierte Abstand zwischen der ersten Platte und der zweiten Platte ist daher in der Regel kleiner als die Höhe des Tropfens gegenüber der ersten Platte und/oder zweiten Platte eingestellt. Die erfindungsgemäße Vorrichtung kann daher mit sehr geringen Volumina an Probe eingesetzt werden. Durch das Einspannen der Probe zwischen den zwei Platten wird zudem die Verdunstung der Probe stark begrenzt oder vermieden. Aufgrund der vergrößerten Kontaktfläche zwischen der Probe und der ersten Platte sowie zwischen der Probe und der zweiten Platte wird die Detektion der durch die Kernspinresonanzen der Probe beeinflussten Größe erleichtert. Die von die Kernspinresonanzen der Probe beeinflusste Größe ist insbesondere eine optische Größe, und insbesondere, eine von den Kernspinresonanzen abhängige Größe. Die erste Platte und/oder die zweite Platte sind beispielsweise transparent ausgestaltet, als Kunststoff oder Glas, wenn die Sensorkomponente einen Teil der ersten Platte und/oder der zweiten Platte bildet. Es ist auch möglich, dass die Sensorkomponente die erste Platte und/oder die zweite Platte vollständig bildet.

Der Mechanismus zur Einstellung der Mess- und der Aufnahmeposition kann derartig ausgestaltet sein, dass die Vorrichtung einteilig oder zweiteilig ausführbar ist. Durch die Möglichkeit der Einstellung der Aufnahmeposition kann die Vorrichtung nicht nur mit der Probe beladen werden, sondern auch auf einfache Weise gereinigt werden.

In einer Ausgestaltung weist die Sensorkomponente zumindest einen Kristallkörper mit zumindest einer Fehlstelle oder um zumindest eine Gaszelle auf. Bei der Gaszelle handelt es sich um eine zumindest ein gasförmiges Alkalimetall einschließende Zelle.

Kristallkörper mit zumindest einer Fehlstelle als auch Gaszellen zeigen unter entsprechender optischer Anregung ein Fluoreszenzsignal, welches unter anderem von einem an dem Kristallkörper oder der Gaszelle anliegenden Magnetfeld abhängig ist. Die Kernspinresonanzen der Probe beeinflussen das an der Sensorkomponente anliegende Magnetfeld, so dass mindestens eine chemische und/oder physikalische Eigenschaft der Probe anhand des Fluoreszenzsignals ermittelbar ist. Hierfür ist ein Kontakt zwischen der Probe und der Sensorkomponente nötig. Durch die vergrößerte Kontaktfläche zwischen der Probe und der ersten Platte sowie zwischen der Probe und der zweiten Platte wird die Sensitivität der Vorrichtung gesteigert. Sowohl der Kristallkörper mit dem zumindest einem Fehlstellen-Zentrum als auch die Gaszelle führen zu einer Verbesserung der Messgenauigkeit der Detektion der Kernspinresonanzen der Probe und damit der mindestens einen chemischen und/oder physikalischen Eigenschaft der Probe aufgrund ihrer hohen Empfindlichkeit gegenüber magnetischen Feldern. Darüber hinaus kann anhand des Fluoreszenzsignals eine Aussage über die magnetische Flussdichte, die magnetische Suszeptibilität, die magnetische Permeabilität oder einer weiteren mit zumindest einer dieser Größen in Beziehung stehenden Größe ermittelt werden.

In einer weiteren Ausgestaltung handelt es sich bei dem Kristallkörper um einen Diamanten mit zumindest einem Stickstoff-Fehlstellen-Zentrum, um Siliziumcarbid mit zumindest einem Silizium-Fehlstellen-Zentrum oder um hexagonales Bornitrid mit zumindest einem Fehlstellen-Farbzentrum.

Bevorzugterweise weist die Sensoreinheit eine Anregungseinheit zur optischen Anregung der Sensorkomponente und eine Detektionseinheit zur Detektion eines von den Kernspinresonanzen der Probe beeinflussten Fluoreszenzsignals der Sensorkomponente auf. Zudem können optional weitere optische Elemente wie Filter, Blenden und Spiegel u.ä. eingesetzt werden.

Vorteilhafterweise sind die Anregungseinheit und/oder die Detektionseinheit benachbart zur ersten Platte und/oder zweiten Platte angeordnet, derart dass ein optischer Strahlengang durch die Probe erzeugbar ist. Die erste Platte und die zweite Platte müssen dabei zumindest teilweise transparent für das Anregungslicht und das Fluoreszenzlicht sein. Die Probe ist insbesondere zwischen der Anregungseinheit und der Detektionseinheit angeordnet. Diese Anordnung hat den Vorteil, dass die Sensorkomponente sowohl als Teilbereich der ersten Platte und als Teilbereich der zweiten Platte ausgebildet werden kann, so dass eine große Kontaktfläche zwischen der Probe und der Sensorkomponente und damit eine hohe Sensitivität der Vorrichtung erreicht wird. Alternativ sind die Anregungseinheit und die Detektionseinheit entweder im Bereich der ersten Platte oder der zweiten Platte angeordnet. In diesem Fall kann zusätzlich eine Reflexionsschicht auf der der Anregungs- und Detektionseinheit gegenüberliegenden Platte aufgebracht sein, um die von der Kernspinresonanz beeinflusste Größe zur Detektionseinheit zu reflektieren.

In einer weiteren Ausgestaltung ist die Detektionseinheit derart ausgestaltet, dass die Detektionseinheit das Fluoreszenzsignal des Kristallkörpers oder der Gaszelle detektiert und das Anregungslicht der Anregungseinheit nicht detektiert. Die Detektionseinheit detektiert im Wesentlichen ausschließlich das Fluoreszenzsignal des Kristallkörpers mit zumindest einer Fehlstelle oder der Gaszelle. Das Fluoreszenzsignal umfasst für gewöhnlich mindestens eine Wellenlänge, typischerweise mehrere Wellenlängen bzw. ein Band an Wellenlängen.

In einer weiteren Ausgestaltung die Detektionseinheit mit einem Absorptionsfilter ausgestattet ist, wobei der Absorptionsfilter zwischen der Detektionseinheit und der ersten Platte oder der zweiten Platte angeordnet ist. Der Absorptionsfilter dient dazu, das Anregungslicht und ggf. weiteres Licht aus der Umgebung zu absorbieren, so dass im Wesentlichen nur das Fluoreszenzsignal auf die Detektionseinheit trifft.

In einer weiteren Ausgestaltung ist der Mechanismus ein Klappmechanismus, wobei der Klappmechanismus insbesondere eine Scharniermechanik umfasst. Durch den Klappmechanismus lässt sich die Vorrichtung auf einfache Weise in die Mess- und die Aufnahmeposition bringen. Insbesondere müssen keine Komponenten der Vorrichtung auseinander gebaut werden, sondern eine Klappbewegung genügt für den Wechsel zwischen den beiden Positionen.

Bevorzugterweise ist ein Induktor vorgesehen, welcher dazu ausgestaltet ist, eine Vorzugspolarisation der Kernspins der Probe zu induzieren. Der Induktor ist insbesondere eine Magnetfeldeinrichtung, welche ein, insbesondere statisches, Magnetfeld zumindest in einem Bereich der Probe und im Bereich der Sensorkomponente erzeugt. Anstelle einer Magnetfeldeinrichtung kann der Induktor auf anderen Methode der Hyperpolarisierung beruhen, also z.B. in Form von durch die Probe geströmten para-Wasserstoff ausgestaltet sein. Es ist auch möglich, den Induktor als Laserquelle und/oder Mikrowellenantenne auszugestalten und somit eine Vorzugspolarisation in den Elektronspins der Sensorkomponente zu induzieren und diese Vorzugspolarisation der Elektronenspins anschließend auf die Kernspins der Probe zu übertragen. Als Laserquelle kann insbesondere die Anregungseinheit eingesetzt werden. Die Mikrowellenantenne kann sowohl zur Induktion einer Vorzugspolarisation der Kernspins der Probe als auch zur Anregung der Sensorkomponente eingesetzt werden.

Vorteilhafterweise ist die Magnetfeldeinrichtung benachbart zur Anregungseinheit und/oder Detektionseinheit angeordnet, derart dass ein homogenes Magnetfeld im Bereich der Probe und im Bereich der Sensorkomponente erzeugbar ist, wobei die Magnetfeldeinrichtung insbesondere als ein Joch oder zweiteilig ausgestaltet ist. In dieser Ausgestaltung weist die Sensoreinheit eine Anregungseinheit zur optischen Anregung der Sensorkomponente und eine Detektionseinheit zur Detektion eines von den Kernspinresonanzen der Probe beeinflussten Fluoreszenzsignals der Sensorkomponente auf.

In einer weiteren Ausgestaltung weist die Probe ein Volumen von unter 100 µl, insbesondere von unter 10 µl, auf.

In einer weiteren Ausgestaltung beträgt der definierte Abstand zwischen erster Platte und zweiter Platte zwischen 1 mm und 100 µm.

In einer weiteren Ausgestaltung ist eine Mikrowellenquelle zur Anregung der Sensorkomponente vorgesehen.

In einer weiteren Ausgestaltung ist die Sensorkomponente als eine Beschichtung auf einer der Probe zugewandten Fläche der ersten Platte und/oder der zweiten Platte ausgestaltet. Im Falle eines Kristallkörpers mit zumindest einer Fehlstelle kann dieser beispielsweise mit einem CVD- oder PVD-Verfahren auf die erste Platte und/oder die zweite Platte aufgetragen werden. Die erste Platte und/oder die zweite Platte dienen als Substrat und sind beispielsweise aus Glas gefertigt.

Im Folgenden soll die Erfindung anhand der Figuren Fig. 1 - 4 näher erläutert werden. Sie zeigen:
Fig. 1: ein vereinfachtes Energieschema für ein negativ geladenes NV-Zentrum im Diamant.
Fig. 2: eine erste Ausgestaltung der erfindungsgemäßen Vorrichtung.
Fig. 3: eine zweite Ausgestaltung der erfindungsgemäßen Vorrichtung.
Fig. 4: eine dritte Ausgestaltung der erfindungsgemäßen Vorrichtung.

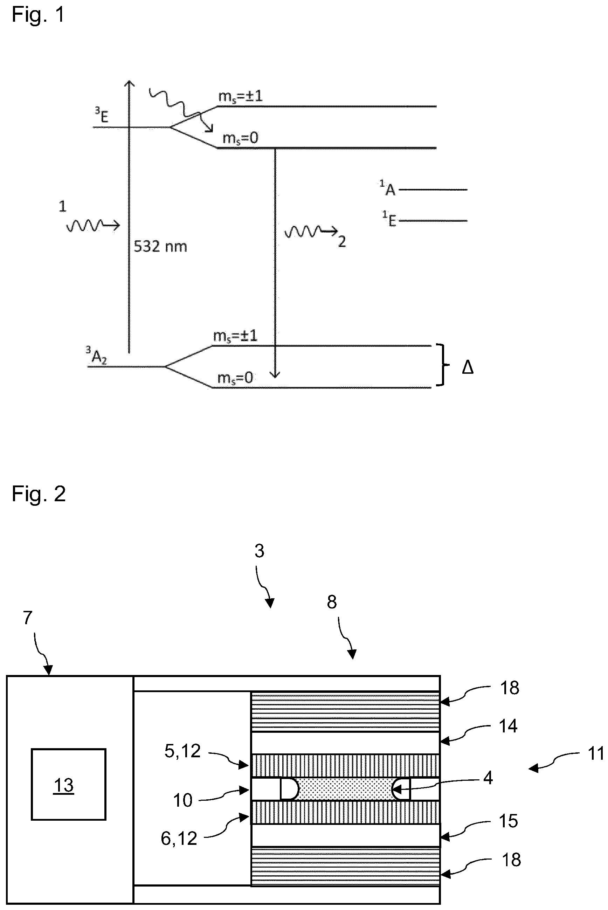

In Fig. 1 ist ein vereinfachtes Energieschema für ein negativ geladenes Stickstoff-Fehlstellen-Zentrum (NV-Zentrum) in einem Diamanten gezeigt, um die Anregung und die Fluoreszenz einer Fehlstelle in einem Kristallkörper beispielhaft zu erläutern. Die folgenden Überlegungen lassen sich auf andere Kristallkörper mit entsprechenden Fehlstellen übertragen.

Im Diamant ist typischerweise jedes Kohlenstoffatom mit vier weiteren Kohlenstoffatomen kovalent verbunden. Ein nitrogen vacancy-Zentrum (NV-Zentrum) besteht aus einer Fehlstelle im Diamantgitter, also einem unbesetzten Gitterplatz, und einem Stickstoffatom als einem der vier Nachbaratome. Insbesondere die negativ geladenen NV⁻-Zentren sind für die Anregung und Auswertung von Fluoreszenzsignalen von Bedeutung. Im Energieschema eines negativ geladenen NV-Zentrums findet sich neben einem Triplett-Grundzustand ³A ein angeregter Triplett-Zustand ³E, welche jeweils drei magnetische Unterzustände mₛ=0,±1 aufweisen. Weiterhin befinden sich zwei metastabile Singulett-Zustände ¹A und ¹E zwischen dem Grundzustand ³A und dem angeregten Zustand ³E. In Abwesenheit eines externen Magnetfelds tritt eine Aufspaltung der beiden Zustände mₛ= +/-1 von dem Grundzustand mₛ=0 auf, welche als Nullfeldaufspaltung Δ bezeichnet wird und welche abhängig von der Temperatur T ist.

Durch Anregungslicht 1 aus dem grünen Bereich des sichtbaren Spektrums, also z.B. ein Anregungslicht 1 mit einer Wellenlänge von 532 nm, findet eine Anregung eines Elektrons aus dem Grundzustand ³A in einen Vibrationszustand des angeregten Zustand ³E statt, welches unter Aussenden eines Fluoreszenz-Photons 2 mit einer Wellenlänge von 630 nm in den Grundzustand ³A zurückkehrt. Dieses Fluoreszenzsignal ist ein Maß für die Nullfeldaufspaltung Δ und kann zur Bestimmung und/oder Überwachung der Temperatur T herangezogen werden.

Ein angelegtes Magnetfeld mit einer Magnetfeldstärke B führt zu einer Aufspaltung (Zeeman-Splitting) der magnetischen Unterzustände, so dass der Grundzustand aus drei energetisch separierten Unterzuständen besteht, von denen jeweils eine Anregung erfolgen kann. Die Intensität des Fluoreszenzsignals ist jedoch abhängig von dem jeweiligen magnetischen Unterzustand, von dem aus angeregt wurde, so dass anhand des Abstands der Fluoreszenzminima beispielsweise die Magnetfeldstärke B mithilfe der Zeeman-Formel berechnet werden kann. Die Magnetfeldstärke B wird durch die Kernspins der Probe 4 modifiziert oder ergibt sich aus diesen.

Im Rahmen der vorliegenden Erfindung sind weitere Möglichkeiten der Auswertung des Fluoreszenzsignals vorgesehen, wie beispielsweise die Auswertung der Intensität des Fluoreszenzlichts, welche dem angelegten Magnetfeld ebenfalls proportional ist. Eine elektrische Auswertung wiederum kann beispielsweise über eine Photocurrent Detection of Magnetic Resonance (engl. kurz PDMR) erfolgen. Neben diesen Beispielen zur Auswertung des Fluoreszenzsignals sind noch weitere Möglichkeiten vorhanden, welche ebenfalls unter die vorliegende Erfindung fallen.

In Fig. 2 ist eine erste Ausgestaltung der erfindungsgemäßen Vorrichtung 3 gezeigt. Mittels des Mechanismus 7 ist eine Messposition 8 eingestellt, in welcher die Probe 4 zwischen der ersten Platte 5 und der zweiten Platte 6 eingeschlossen ist. Der Mechanismus 7 kann beispielsweise ein Aufklappen oder ein Auseinandernehmen der Vorrichtung 3 bewirken. In der Messposition 8 sind die erste Platte 5 und die zweite Platte 6 im Wesentlichen parallel zueinander ausgerichtet. Durch einen Abstandshalter 10 wird ein definierter Abstand zwischen der ersten Platte 5 und der zweiten Platte 6 eingestellt. Beispielsweise beträgt der definierte Abstand zwischen 1 mm und 100 µm.

Die Sensoreinheit 11 weist eine Sensorkomponente 12 auf, welche zumindest einen Teilbereich der ersten Platte 5 und/oder der zweiten Platte 6 bildet. Im Beispiel der Fig. 2 besteht die erste Platte 5 und die zweite Platte 6 vollständig aus der Sensorkomponente 12. Die Sensorkomponente 12 ist beispielsweise zumindest ein Kristallkörper mit zumindest einer Fehlstelle oder zumindest eine Gaszelle. Bei dem Kristallkörper handelt es sich optional um einen Diamanten mit zumindest einem Stickstoff-Fehlstellen-Zentrum oder mit zumindest einem Silizium-Fehlstellen-Zentrum, um Siliziumcarbid mit zumindest einem Silizium-Fehlstellen-Zentrum oder um hexagonales Bornitrid mit zumindest einem Fehlstellen-Farbzentrum. Die Gaszelle beinhaltet beispielsweise ein gasförmiges Alkalimetall in einer Zelle.

Zu der Sensoreinheit 11 können optional auch eine Anregungseinheit 14 für die optische Anregung der Sensorkomponente 12 und eine Detektionseinheit 15 zur Detektion des von den Kernspinresonanzen der Probe 4 beeinflussten Fluoreszenzsignals der Sensorkomponente 12, welche beispielhaft benachbart zur ersten Platte 5 und zur zweiten Platte 6 angeordnet sind. Auf diese Weise ist ein optische Strahlengang durch die Probe 4 möglich. Zur Ermittlung der mindestens einen chemischen und/oder physikalischen Eigenschaft der Probe 4 anhand der detektierten Größe ist weiterhin eine Auswerteeinheit 13 angeordnet. Zur Anzeige und/oder zur Übermittlung der mindestens einen chemischen und/oder physikalischen Größe an eine externe Einheit können optional noch eine Sendeeinheit und/oder eine Anzeigeeinheit vorhanden sein.

Für die Induktion einer Vorzugspolarisation der Kernspins der Probe 4 ist ein optionaler Induktor 17 vorgesehen, welche im Beispiel der Fig. 2 als eine Magnetfeldeinrichtung 18 dargestellt ist. Die Magnetfeldeinrichtung 18 erzeugt zumindest im Bereich der Probe 4 und im Bereich des Sensorkomponente ein homogenes Magnetfeld und ist in Fig. 2 zweiteilig ausgestaltet. In der Messposition 8 ergibt sich damit ein magnetisches Joch.

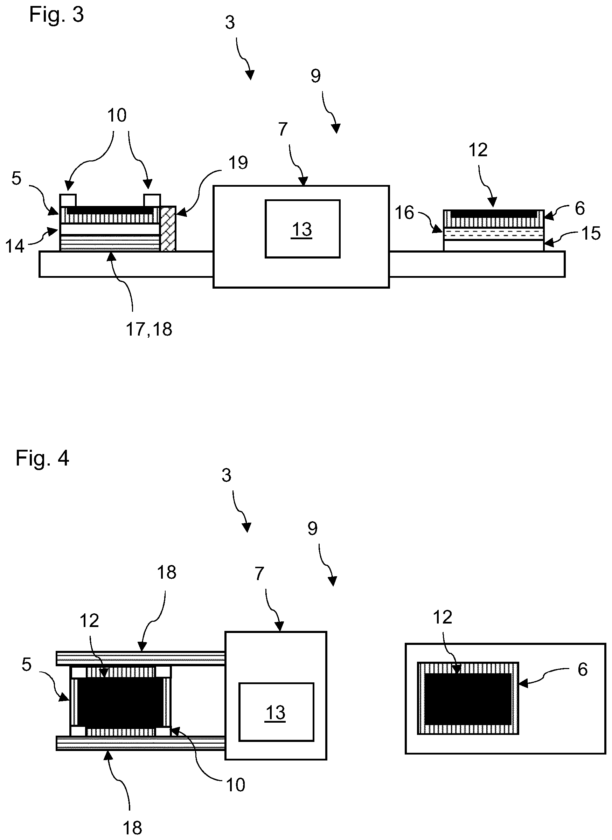

In Fig. 3 ist eine zweite Ausgestaltung der erfindungsgemäßen Vorrichtung 3 gezeigt, wobei der Mechanismus 7 in diesem Beispiel eine Aufnahmeposition 9 eingestellt hat, indem die Vorrichtung 3 zwischen der ersten Platte 5 und der zweiten Platte 6 aufgeklappt wurde. Der Mechanismus 7 ist beispielsweise ein Klappmechanismus und umfasst eine Scharniermechanik. In der Aufnahmeposition 9 kann auf einfache Weise die flüssige oder pastöse Probe 4 in Form eines Tropfens auf die erste Platte 5 oder die zweite Platte 6 aufgebracht werden. Die Probe weist beispielsweise ein Volumen von unter 100 µl, insbesondere von unter 10 µl, auf.

Die Detektionseinheit 15 ist optional derartig ausgestaltet, dass die Detektionseinheit 15 im Wesentlichen nur das Fluoreszenzsignal der Sensorkomponente 12 detektiert. Beispielsweise wird dies mit einem Absorptionsfilter 16 erreicht, welcher zwischen der Detektionseinheit 15 und der zweiten Platte 6 angeordnet ist. Zusätzlich ist eine Mikrowellenquelle 19 im Bereich der Sensorkomponente 12 zur Anregung der Sensorkomponente 12 angeordnet. Die Sensorkomponente 12 ist beispielhaft als eine Beschichtung auf je einer Fläche der ersten Platte 5 und der zweiten Platte 6 dargestellt, welche jeweils der Probe 4 zugewandt sind.

In Fig. 4 ist eine vierte Ausgestaltung der erfindungsgemäßen Vorrichtung 3 gezeigt, welche in diesem Beispiel zweiteilig ausgeführt ist. Im Gegensatz zu den Figuren Fig. 2-3 wird keine Seitenansicht, sondern eine Aufsicht gezeigt. In diesem Beispiel ist die Magnetfeldeinrichtung 18 als ein Joch ausgestaltet, welches in der Aufnahmeposition 9 die erste Platte 5 umgibt. Wird die zweite Platte 6 in den Mechanismus 7 beispielsweise eingeclipst oder angefügt, ist die zweite Platte 6 in der Messposition 8 ebenso von der Magnetfeldeinrichtung 18 umgeben.

### Bezugszeichenliste

- 1: Anregungslicht
- 2: Fluoreszenzlicht
- 3: Vorrichtung
- 4: Probe
- 5: erste Platte
- 6: zweite Platte
- 7: Mechanismus
- 8: Messposition
- 9: Aufnahmeposition
- 10: Abstandshalter
- 11: Sensoreinheit
- 12: Sensorkomponente
- 13: Auswerteeinheit
- 14: Anregungseinheit
- 15: Detektionseinheit
- 16: Absorptionsfilter
- 17: Induktor
- 18: Magnetfeldeinrichtung
- 19: Mikrowellenquelle

## Patentansprüche

1. Vorrichtung (3) für die Analyse einer als Tropfen bereitgestellten flüssigen oder pastösen Probe (4) anhand von Kernspinresonanzen der Probe (4), mit
- einer ersten Platte (5) und einer zweiten Platte (6),
- einem Mechanismus (7), über welchen eine Messposition (8) und eine Aufnahmeposition (9) einstellbar ist, wobei in der Aufnahmeposition (9) die Probe (4) zwischen der ersten Platte (5) und der zweiten Platte (6) einbringbar ist, wobei in der Messposition (8) die erste Platte (5) und die zweite Platte (6) im Wesentlichen parallel zueinander angeordnet sind und ein Abstandshalter (10) einen definierten Abstand zwischen der ersten Platte (5) und der zweiten Platte (6) einstellt,
- einer Sensoreinheit (11) mit einer Sensorkomponente (12), welche zumindest einen Teilbereich der ersten Platte (5) und/oder der zweiten Platte (6) bildet und zumindest teilweise in Kontakt mit der Probe (4) steht, wobei die Sensoreinheit (11) dazu ausgestaltet ist, eine von den Kernspinresonanzen der Probe (4) beeinflusste Größe zu detektieren,
- einer Auswerteeinheit (13), welche ausgestaltet ist, anhand der detektierten Größe mindestens eine chemische und/oder physikalische Eigenschaft der Probe (4) zu ermitteln.

2. Vorrichtung nach Anspruch 1,
wobei die Sensorkomponente (12) zumindest einen Kristallkörper mit zumindest einer Fehlstelle oder um zumindest eine Gaszelle aufweist, wobei es sich bei der Gaszelle um eine zumindest ein gasförmiges Alkalimetall einschließende Zelle handelt.

3. Vorrichtung nach Anspruch 2,
wobei es sich bei dem Kristallkörper um einen Diamanten mit zumindest einem Stickstoff-Fehlstellen-Zentrum oder mit zumindest einem Silizium-Fehlstellen-Zentrum, um Siliziumcarbid mit zumindest einem Silizium-Fehlstellen-Zentrum oder um hexagonales Bornitrid mit zumindest einem Fehlstellen-Farbzentrum handelt.

4. Vorrichtung nach mindestens einem der Ansprüche 1-3,
wobei die Sensoreinheit (11) eine Anregungseinheit (14) zur optischen Anregung der Sensorkomponente (12) und eine Detektionseinheit (15) zur Detektion eines von den Kernspinresonanzen der Probe (4) beeinflussten Fluoreszenzsignals der Sensorkomponente (12) aufweist.

5. Vorrichtung nach Anspruch 4,
wobei die Anregungseinheit (14) und/oder die Detektionseinheit (15) benachbart zur ersten Platte (5) und/oder zweiten Platte (6) angeordnet sind, derart dass ein optischer Strahlengang durch die Probe (4) erzeugbar ist.

6. Vorrichtung nach Anspruch 5,
wobei die Detektionseinheit (15) derart ausgestaltet ist, dass die Detektionseinheit (15) das Fluoreszenzsignal der Sensorkomponente (12) detektiert und das Anregungslicht der Anregungseinheit (14) nicht detektiert.

7. Vorrichtung nach Anspruch 6,
wobei die Detektionseinheit (15) mit einem Absorptionsfilter (16) ausgestattet ist, wobei der Absorptionsfilter (16) zwischen der Detektionseinheit (15) und der ersten Platte (5) oder der zweiten Platte (6) angeordnet ist.

8. Vorrichtung nach mindestens einem der Ansprüche 1-7,
wobei der Mechanismus (7) ein Klappmechanismus ist, wobei der Klappmechanismus insbesondere eine Scharniermechanik umfasst.

9. Vorrichtung nach mindestens einem der Ansprüche 1-8,
wobei ein Induktor (17) vorgesehen ist, welcher dazu ausgestaltet ist, eine Vorzugspolarisation der Kernspins der Probe (4) zu induzieren, wobei der Induktor (17) insbesondere eine Magnetfeldeinrichtung (18) ist, welche ein Magnetfeld zumindest in einem Bereich der Probe (4) erzeugt.

10. Vorrichtung nach Anspruch 9,
wobei die Sensoreinheit (11) eine Anregungseinheit (14) zur optischen Anregung der Sensorkomponente (12) und eine Detektionseinheit (15) zur Detektion eines von den Kernspinresonanzen der Probe (4) beeinflussten Fluoreszenzsignals der Sensorkomponente (12) aufweist, wobei die Magnetfeldeinrichtung (18) benachbart zur Anregungseinheit (14) und/oder Detektionseinheit (15) angeordnet ist, derart dass ein homogenes Magnetfeld im Bereich der Probe (4) erzeugbar ist, wobei die Magnetfeldeinrichtung (18) insbesondere als ein Joch oder zweiteilig ausgestaltet ist.

11. Vorrichtung nach mindestens einem der Ansprüche 1-10,
wobei die Probe (4) ein Volumen von unter 100 µl, insbesondere von unter 10 µl, aufweist.

12. Vorrichtung nach mindestens einem der Ansprüche 1-11,
wobei der definierte Abstand zwischen erster Platte (5) und zweiter Platte (6) zwischen 1 mm und 100 µm beträgt.

13. Vorrichtung nach mindestens einem der Ansprüche 1-12,
wobei die Sensorkomponente (12) als eine Beschichtung auf einer der Probe (4) zugewandten Fläche der ersten Platte (5) und/oder der zweiten Platte (6) ausgestaltet ist.

## Claims

1. Device (3) for analyzing a liquid or pasty sample (4) provided in the form of drops on the basis of nuclear magnetic resonances of the sample (4), comprising
- a first plate (5) and a second plate (6),
- a mechanism (7) by means of which a measuring position (8) and a receiving position (9) can be adjusted, wherein in the receiving position (9) the sample (4) can be introduced between the first plate (5) and the second plate (6), wherein in the measuring position (8) the first plate (5) and the second plate (6) are arranged essentially parallel to each other and a spacer (10) sets a defined distance between the first plate (5) and the second plate (6),
- a sensor unit (11) with a sensor component (12) which forms at least a partial area of the first plate (5) and/or the second plate (6) and is at least partially in contact with the sample (4), wherein the sensor unit (11) is designed to detect a variable influenced by the nuclear magnetic resonances of the sample (4),
- an evaluation unit (13) which is designed to determine at least one chemical and/or physical property of the sample (4) on the basis of the detected quantity.

2. Device according to claim 1,
wherein the sensor component (12) has at least one crystal body with at least one defect or at least one gas cell, wherein the gas cell is a cell enclosing at least one gaseous alkali metal.

3. Device according to claim 2,
wherein the crystal body is a diamond with at least one nitrogen vacancy center or with at least one silicon vacancy center, silicon carbide with at least one silicon vacancy center, or hexagonal boron nitride with at least one vacancy color center.

4. Device according to at least one of claims 1-3,
wherein the sensor unit (11) has an excitation unit (14) for optically exciting the sensor component (12) and a detection unit (15) for detecting a fluorescence signal of the sensor component (12) influenced by the nuclear magnetic resonances of the sample (4).

5. Device according to claim 4,
wherein the excitation unit (14) and/or the detection unit (15) are arranged adjacent to the first plate (5) and/or the second plate (6) in such a way that an optical beam path can be generated through the sample (4).

6. Device according to claim 5,
wherein the detection unit (15) is designed such that the detection unit (15) detects the fluorescence signal of the sensor component (12) and does not detect the excitation light of the excitation unit (14).

7. Device according to claim 6,
wherein the detection unit (15) is equipped with an absorption filter (16), wherein the absorption filter (16) is arranged between the detection unit (15) and the first plate (5) or the second plate (6).

8. Device according to at least one of claims 1-7,
wherein the mechanism (7) is a hinge mechanism, wherein the hinge mechanism comprises in particular a hinge mechanism.

9. Device according to at least one of claims 1-8,
wherein an inductor (17) is provided, which is designed to induce a preferential polarization of the nuclear spins of the sample (4), wherein the inductor (17) is in particular a magnetic field device (18) which generates a magnetic field at least in a region of the sample (4).

10. Device according to claim 9,
wherein the sensor unit (11) has an excitation unit (14) for optically exciting the sensor component (12) and a detection unit (15) for detecting a fluorescence signal of the sensor component (12) influenced by the nuclear magnetic resonances of the sample (4) (12) influenced by the nuclear magnetic resonances of the sample (4),
wherein the magnetic field device (18) is arranged adjacent to the excitation unit (14) and/or detection unit (15) in such a way that a homogeneous magnetic field can be generated in the region of the sample (4), wherein the magnetic field device (18) is designed in particular as a yoke or in two parts.

11. Device according to at least one of claims 1-10,
wherein the sample (4) has a volume of less than 100 µl, in particular less than 10 µl.

12. Device according to at least one of claims 1-11,
wherein the defined distance between the first plate (5) and the second plate (6) is between 1 mm and 100 µm.

13. Device according to at least one of claims 1-12,
wherein the sensor component (12) is designed as a coating on a surface of the first plate (5) and/or the second plate (6) facing the sample (4).

## Revendications

1. Dispositif (3) pour l'analyse d'un échantillon liquide ou pâteux (4) présenté sous forme de gouttes, à l'aide de résonances magnétiques nucléaires de l'échantillon (4), comprenant
- une première plaque (5) et une deuxième plaque (6),
- un mécanisme (7) permettant de régler une position de mesure (8) et une position de réception (9), l'échantillon (4) pouvant être placé entre la première plaque (5) et la deuxième plaque (6) dans la position de réception (9), la première plaque (5) (5) et la deuxième plaque (6) sont disposées essentiellement parallèlement l'une à l'autre et une entretoise (10) définit une distance définie entre la première plaque (5) et la deuxième plaque (6),
- une unité de détection (11) avec un composant de détection (12) qui forme au moins une partie de la première plaque (5) et/ou de la deuxième plaque (6) et est au moins partiellement en contact avec l'échantillon (4), l'unité de capteur (11) étant conçue pour détecter une grandeur influencée par les résonances magnétiques nucléaires de l'échantillon (4),
- une unité d'évaluation (13) qui est conçue pour déterminer au moins une propriété chimique et/ou physique de l'échantillon (4) à partir de la grandeur détectée.

2. Dispositif selon la revendication 1,
dans lequel le composant capteur (12) comporte au moins un corps cristallin avec au moins un défaut ou autour d'au moins une cellule gazeuse, la cellule gazeuse étant une cellule renfermant au moins un métal alcalin gazeux.

3. Dispositif selon la revendication 2,
le corps cristallin étant un diamant comportant au moins un centre de lacune d'azote ou au moins un centre de lacune de silicium, du carbure de silicium comportant au moins un centre de lacune de silicium ou du nitrure de bore hexagonal comportant au moins un centre de lacune coloré.

4. Dispositif selon au moins l'une des revendications 1 à 3,
l'unité de détection (11) comportant une unité d'excitation (14) pour l'excitation optique du composant de détection (12) et une unité de détection (15) pour la détection d'un signal de fluorescence du composant de détection (12) influencé par les résonances magnétiques nucléaires de l'échantillon (4).

5. Dispositif selon la revendication 4,
dans lequel l'unité d'excitation (14) et/ou l'unité de détection (15) sont disposées à proximité de la première plaque (5) et/ou de la deuxième plaque (6) de telle sorte qu'un trajet optique puisse être généré à travers l'échantillon (4).

6. Dispositif selon la revendication 5,
dans lequel l'unité de détection (15) est conçue de telle sorte que l'unité de détection (15) détecte le signal de fluorescence du composant capteur (12) et ne détecte pas la lumière d'excitation de l'unité d'excitation (14).

7. Dispositif selon la revendication 6,
dans lequel l'unité de détection (15) est équipée d'un filtre d'absorption (16), le filtre d'absorption (16) étant disposé entre l'unité de détection (15) et la première plaque (5) ou la deuxième plaque (6).

8. Dispositif selon au moins l'une des revendications 1 à 7,
dans lequel le mécanisme (7) est un mécanisme à clapet, le mécanisme à clapet comprenant en particulier un mécanisme à charnière.

9. Dispositif selon au moins l'une des revendications 1 à 8,
dans lequel est prévu un inducteur (17) qui est conçu pour induire une polarisation préférentielle des spins nucléaires de l'échantillon (4), l'inducteur (17) étant en particulier un dispositif à champ magnétique (18) qui génère un champ magnétique au moins dans une zone de l'échantillon (4).

10. Dispositif selon la revendication 9,
dans lequel l'unité de capteur (11) comprend une unité d'excitation (14) pour l'excitation optique du composant de capteur (12) et une unité de détection (15) pour la détection d'un signal de fluorescence du composant de capteur influencé par les résonances magnétiques nucléaires de l'échantillon (4) (12) influencé par les résonances magnétiques nucléaires de l'échantillon (4),
le dispositif à champ magnétique (18) étant disposé à proximité de l'unité d'excitation (14) et/ou de l'unité de détection (15) de telle sorte qu'un champ magnétique homogène puisse être généré dans la zone de l'échantillon (4), le dispositif à champ magnétique (18) étant notamment conçu sous la forme d'une culasse ou en deux parties.

11. Dispositif selon au moins l'une des revendications 1 à 10,
l'échantillon (4) présentant un volume inférieur à 100 µl, en particulier inférieur à 10 µl.

12. Dispositif selon au moins l'une des revendications 1 à 11,
la distance définie entre la première plaque (5) et la deuxième plaque (6) étant comprise entre 1 mm et 100 µm.

13. Dispositif selon au moins l'une des revendications 1 à 12,
le composant capteur (12) étant conçu sous la forme d'un revêtement sur une surface de la première plaque (5) et/ou de la deuxième plaque (6) tournée vers l'échantillon (4).
